# EUROPÄISCHE PATENTANMELDUNG

(11) **EP 3 813 203 A1**
(43) Veröffentlichungstag der Anmeldung: **28.04.2021**
(21) Anmeldenummer: 19205436.9
(22) Anmeldetag: 25.10.2019
(51) Int. Cl.: H01R 13/193, G01R 1/04, G01R 31/58, H01R 13/629, H01R 11/18

(54) **KABELPRÜFVORRICHTUNG**

(71) Anmelder: Schleuniger AG, 3608 Thun (CH)
(72) Erfinder: PODOLSKI, Werner, 72285 Pfalzgrafenweiler (DE); MESSER, Michael, 75217 Birkenfeld (DE)
(74) Vertreter: Patentbüro Paul Rosenich AG

(57) **Zusammenfassung**

Die Erfindung bezieht sich auf eine Kabelprüfvorrichtung (10) mit zumindest einer ersten Kontaktiereinrichtung (3) zur temporären elektrischen Kontaktierung eines ersten Kabelabschnittes (5) eines Kabels (20), insbesondere eines ersten Kabelendes, wobei die zumindest eine erste Kontaktiereinrichtung (3) eine, vorzugsweise zylinderförmige, Aufnahme (4) zum Aufnehmen des ersten Kabelabschnittes (5) und ein im Bereich der Aufnahme (4) angeordnetes erstes Kontaktelement (1) zur Herstellung eines ersten elektrischen Kontaktes zu einem in der Aufnahme (4) befindlichen ersten Kabelabschnitt (5) aufweist, dadurch gekennzeichnet, dass die zumindest eine erste Kontaktiereinrichtung (3) ein im Bereich der Aufnahme (4) angeordnetes zweites Kontaktelement (2) zur Herstellung eines zweiten elektrischen Kontaktes zu einem in der Aufnahme (4) befindlichen ersten Kabelabschnitt (5) aufweist.

## Beschreibung

Die Erfindung betrifft eine Kabelprüfvorrichtung nach dem Oberbegriff des Anspruchs 1 und ein Verfahren zur Prüfung eines Kabels gemäss dem Oberbegriff des Anspruch 16.

Im aktuellen Marktumfeld wird immer mehr der Bedarf an elektrischer Prüfung von Kabeln gefordert. Hierbei gibt es zwei unterschiedliche Arten, die sich in Verbindungskabel (beide Seiten haben einen Stecker/Buchse mit dazwischen definierter Kabellänge) oder Einbaustecker/Einbaubuchsen (diese haben den Stecker/Buchse nur an einer Seite), das andere Ende wird nicht mittels eines Steckers/Buchse bestückt. Dies bezeichnet man dann als offenes Ende. Dieses offene Ende, kann glatt abgeschnitten oder abisoliert sein oder mittels eines Crimpkontaktes versehen sein.

Das elektrische Prüfen von Verbindungsleitungen (Stecker/Buchse an beiden Enden) ist mittels Adaptern mit entsprechenden Federstiften/kontakten bewährt und Stand der Technik.

Jedoch gibt es für das Prüfen von Leitungen, welche an einem oder an beiden Enden offen (steckerlos bzw. buchsenlos) sind bisher nur Hilfslösungen, die keine prozesssichere Kontaktierung gewährleisten und keine zuverlässigen Messungen ermöglichen. Der entsprechende Aufwand für die Re-Kontaktierung ist hierbei sehr hoch.

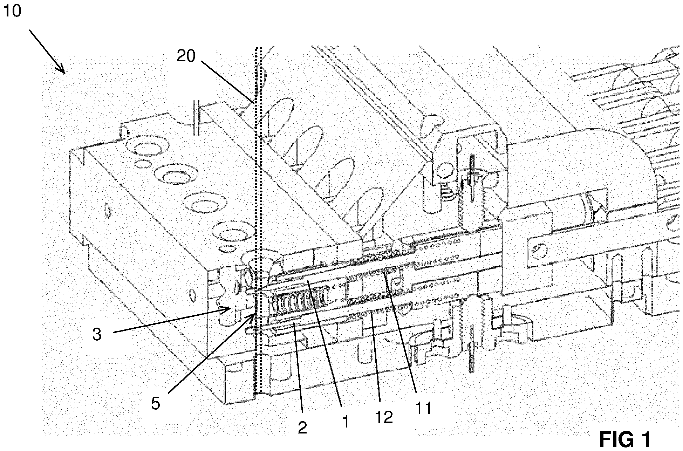

Die DE3308178C1 beschäftigt sich mit der Prüfung von Elektronikteilen, deren elektronische Elemente mit Leitungsenden versehen sind, wobei an den Leitungsenden entweder Flachstecker, Adernendhüllen angebracht sind, oder die Leitungsenden blank oder verlötet sind. Dabei wird das Kabelende (siehe Fig. 1) von oben eingeführt und seitlich geklemmt.

Die US20060172586A1 offenbart eine Testvorrichtung mit einer Aufnahme für einen Kabelabschnitt. Dabei wird mit einer Art Nadel die Isolierung perforiert, um einen elektrischen Kontakt mit der Litze herzustellen.

Auch bei den vorgenannten Druckschriften ergeben sich Problem hinsichtlich fehlender Prozesssicherheit, einer sehr hohen Re-Kontaktierungsrate und fehlender Aussage über die Kontaktierungsqualität und damit mangelnder Aussagekraft der Prüfergebnisse. Dieses Problem verschärft sich insbesondere bei sehr kleinen Litzendurchmessern.

Das Ziel der vorliegenden Erfindung besteht somit darin, die sich aus dem Stand der Technik ergebenden Nachteile zu überwinden und eine Kabelprüfvorrichtung bereitzustellen, mit der eine zuverlässige, reproduzierbare und prozesssichere Kontaktierung von offenen Kabelenden (z.B. glatt, abisoliert oder gecrimpt) ermöglicht wird. Die Kabelprüfvorrichtung soll einfach handhabbar bzw. bedienbar sein. Die Herstellung des elektrischen Kontaktes zum betreffenden kabelabschnitt soll einfach und ohne Fehlerquellen möglich sein.

Dieses Ziel wird mit einer eingangs erwähnten Kabelprüfvorrichtung dadurch erreicht, dass die zumindest eine Kontaktiereinrichtung ein im Bereich der Aufnahme angeordnetes zweites Kontaktelement zur Herstellung eines zweiten elektrischen Kontaktes zu einem in der Aufnahme befindlichen Kabelabschnitt aufweist.

Durch die erfindungsgemässe Massnahme erfolgt nicht nur eine zuverlässige und reproduzierbare Kontaktierung, sondern kann eine echte Vierleitermessung (auch 4-Drahtmessung oder Kelvinkontaktierung genannt) durchgeführt werden. Mit der Kontaktiereinrichtung können auch Kabel mit kleinem Litzendurchmesser (< 1,5mm²) zuverlässig kontaktiert und einer genauen Prüfung unterzogen werden.

Die Aufnahme ist vorzugsweise derart ausgebildet, dass der das Kabelende bildende Kabelabschnitt entlang seiner Längserstreckung über eine Öffnung in die Aufnahme einführbar ist.

Es ist bevorzugt, wenn das erste Kontaktelement und das zweite Kontaktelement - in Abwesenheit eines Kabelabschnittes in der Aufnahme bzw. in der nicht kontaktierenden Stellung - galvanisch voneinander getrennt sind. Dadurch wird die Vierleitermessanordnung ermöglicht.

Die mit der Kabelprüfvorrichtung durchführbare Prüfung kann eine qualitative Prüfung (z.B. eine Prüfung dahingehend, ob die Kabellitze zwischen den Enden des Kabels durchgehend ist, d.h. keine Unterbrechung aufweist) und/oder eine quantitative Prüfung (z.B. eine Messung des elektrischen Widerstandes der Kabellitze) umfassen.

Unter dem Begriff "Kabel" werden in vorliegender Anmeldung auch einpolige und mehrpolige Kabel, Kabel in Form von Kabelbäumen, Flachkabel, Kabel mit Verzweigungen sowie Kabel beliebiger Form und Ausführung verstanden.

Die Kontaktelemente sind zumindest mit ihrer Kontaktfläche oder - punkt in der Aufnahme angeordnet und/oder in diese hineinbewegbar. Es ist bevorzugt, wenn zumindest ein Kontaktelement, vorzugsweise beide Kontaktelemente, als Klemmelement ausgebildet ist/sind bzw. wirkt/-en und den ersten Kabelabschnitt in der Kontaktierstellung mechanisch klemmt/-en.

Die erste Kontaktiereinrichtung mit der Aufnahme, dem ersten und zweiten Kontaktelement dient der Kontaktierung des Kabels an einem ersten Abschnitt, insbesondere an einem offenen (d.h. steckerlosen bzw. buchsenlosen) ersten Ende des Kabels. Zusätzlich kann die Prüfvorrichtung eine zweite Kontaktiereinrichtung aufweisen, welche zur Kontaktierung eines zweiten Abschnittes, insbesondere des zweiten Endes, des Kabels dient. Es ist bevorzugt, dass auch die zweite Kontaktiereinrichtung zwei Kontaktelemente umfasst, um auf diese Weise eine Vierleitermessanordnung (bzw. Kelvinkontaktierung) zu ermöglichen. Die zweite Kontaktiereinrichtung kann gleich, ähnlich oder verschieden zu der ersten Kontaktiereinrichtung sein.

Eine bevorzugte Ausführungsform zeichnet sich dadurch aus, dass die Kabelprüfvorrichtung eine Vierleitermessanordnung mit einem Kreis zur Beaufschlagung eines Kabels mit Strom oder Spannung und einem Messkreis umfasst, wobei das erste Kontaktelement Teil des Beaufschlagungskreises und das zweite Kontaktelement Teil des Messkreises ist. Eine Vierleitermessung ermöglicht eine besonders genaue Messung der elektrischen Kabeleigenschaften, insbesondere des Widerstandes, da diese weitgehend unabhängig von den Innenwiderständen der Messkreise und der Kontaktwiderstände ist. Mit den beiden Kontaktelementen in der Aufnahme wird eine solche Kontaktierung auf einfache Weise ermöglicht.

Eine bevorzugte Ausführungsform zeichnet sich dadurch aus, dass das erste Kontaktelement mit einer Stromquelle oder einer Spannungsquelle, vorzugsweise über eine Schalteinrichtung, verbunden ist und/oder dass das zweite Kontaktelement mit einem Voltmeter oder einem Amperemeter, vorzugsweise über eine Schalteinrichtung, verbunden ist.

Eine bevorzugte Ausführungsform zeichnet sich dadurch aus, dass die Kabelprüfvorrichtung zumindest eine zweite Kontaktiereinrichtung zur temporären elektrischen Kontaktierung eines zweiten Kabelabschnittes eines Kabels, insbesondere eines zweiten (vorzugsweise mit einem Stecker oder einer Buchse bestückten) Kabelendes, aufweist. Dies ermöglicht auch die zuverlässige Kontaktierung des zweiten Kabelendes.

Eine bevorzugte Ausführungsform zeichnet sich dadurch aus, dass die zumindest eine zweite Kontaktiereinrichtung ein erstes Kontaktelement zur Herstellung eines ersten elektrischen Kontaktes zu dem zweiten Kabelabschnitt und ein zweites Kontaktelement zur Herstellung eines zweiten elektrischen Kontaktes zu dem zweiten Kabelabschnitt umfasst. Dies ermöglicht wiederum die Vierleitermessung an dem zu prüfenden Kabel.

Eine bevorzugte Ausführungsform zeichnet sich dadurch aus, dass die Kabelprüfvorrichtung eine Vierleitermessanordnung mit einem Kreis zur Beaufschlagung eines Kabels mit Strom oder Spannung und einem Messkreis umfasst, wobei das erste Kontaktelement (der zweiten Kontaktiereinrichtung) Teil des Beaufschlagungskreises und das zweite Kontaktelement (der zweiten Kontaktiereinrichtung) Teil des Messkreises ist.

Eine bevorzugte Ausführungsform zeichnet sich dadurch aus, dass das erste Kontaktelement und/oder das zweite Kontaktelement mit einer Leuchteinrichtung, insbesondere einer Leuchtdiode, zur Anzeige des Kontaktierungszustandes elektrisch verbunden ist/sind. Dies ermöglicht während der Kontaktierung die sofortige Anzeige des Kontaktierstatus.

Eine bevorzugte Ausführungsform zeichnet sich dadurch aus, dass die Aufnahme eine Führung für den aufzunehmenden Kabelabschnitt ausbildet, wobei die Führung eine Längsachse aufweist. Das Kabel(ende) wird dabei über eine Öffnung in die Aufnahme bzw.

Führung eingeführt. Bevorzugt ist der Durchmesser der Führung in etwa gleich gross wie der Durchmesser des zu prüfenden Kabels. Dadurch ist gewährleistet, dass die Kontaktelemente an der richtigen Stelle den Kabelabschnitt kontaktieren.

Die Erfindung bietet hohe Flexibilität, da mit der derselben Kontaktiereinheit verschiedene Kabelquerschnitte innerhalb eines Bereiches (z.B. von 0,09 mm² bis 1,5 mm²) sicher kontaktiert werden können.

Eine bevorzugte Ausführungsform zeichnet sich dadurch aus, dass die Aufnahme, zumindest ein Abschnitt des ersten Kontaktelementes und zumindest ein Abschnitt des zweiten Kontaktelementes in einem gemeinsamen Block untergebracht sind. Beispielsweise kann/können die Aufnahme für den Kabelabschnitt und/oder die Unterbringung des ersten Kontaktelements und/oder die Unterbringung des zweiten Kontaktelements (jeweils) als eine Bohrung innerhalb des Blockes ausgeführt sein.

Eine bevorzugte Ausführungsform zeichnet sich dadurch aus, dass zumindest eines der Kontaktelemente, vorzugsweise beide Kontaktelemente, relativ zur Aufnahme zwischen einer Trennstellung und einer Kontaktierungsstellung bewegbar ist/sind, vorzugsweise in einer Richtung quer, bevorzugt senkrecht, zur Längsachse der Aufnahme, wobei vorzugsweise zumindest eines der Kontaktelemente, vorzugsweise beide Kontaktelemente, in zumindest einer Stellung, vorzugsweise in der Kontaktierungsstellung, durch eine Feder vorgespannt ist/sind. In der Trennstellung ist das /sind die Kontaktelement(e) zurückgezogen bzw. überhaupt aus der Aufnahme bewegt. Dies ermöglicht das ungehinderte Einführen des Kabels. Ist das Kabel eingeführt, wird/werden das/die Kontaktelement(e) in Richtung des Inneren der Aufnahme bewegt und kontaktieren (bzw. klemmen) den Kabelabschnitt.

Eine bevorzugte Ausführungsform zeichnet sich dadurch aus, dass das erste Kontaktelement und das zweite Kontaktelement mit einem gemeinsamen Betätigungselement zusammenwirken und gemeinsam von einer Trennstellung in eine Kontaktierungsstellung bewegbar sind, wobei vorzugsweise das Betätigungselement ein schwenkbar gelagerter Hebel ist. Die Betätigung kann händisch oder auch automatisch durch einen Antrieb erfolgen.

Eine bevorzugte Ausführungsform zeichnet sich dadurch aus, dass das erste Kontaktelement und das zweite Kontaktelement mit dem Betätigungselement derart verbunden sind, dass beim Betätigen der Betätigungselementes ein Kontaktelement dem anderen Kontaktelement vorauseilt. Dies ist insbesondere dann von Vorteil, wenn die Kontaktelemente dazu vorgesehen sind, die Kabelisolierung zu perforieren um die Litze zu kontaktieren. Die dafür erforderliche Kraft wird durch diese Massnahme reduziert bzw. verteilt.

Eine bevorzugte Ausführungsform zeichnet sich dadurch aus, dass das erste Kontaktelement und/oder das zweite Kontaktelement mit einem Betätigungselement zusammenwirken, wobei das Betätigungselement Bestandteil einer Kinematik ist, die zwischen der Trennstellung und der Kontaktierungsstellung einen Totpunkt aufweist. Auf diese Weise wird gewährleistet, dass sowohl die Kontaktierstellung wie auch die Trennstellung stabile Stellungen sind, die nicht unbeabsichtigt (z.B. durch Stösse oder Vibrationen) verlassen werden können.

Eine bevorzugte Ausführungsform zeichnet sich dadurch aus, dass die Aufnahme eine Längsachse aufweist und dass zumindest eines der Kontaktelemente, vorzugsweise beide Kontaktelemente, in Form eines Kontaktstiftes, welcher sich quer, vorzugsweise senkrecht, zur Längsachse der Aufnahme erstreckt, ausgebildet ist/sind, wobei vorzugsweise das dem Inneren der Aufnahme zugewandte Ende des Kontaktstiftes zulaufend, vorzugsweise spitz zulaufend, ausgebildet ist. Derart ausgebildete Kontaktstifte eignen sich besonders als Klemmelemente, welche gegen das Kabel bzw. dessen Litze drücken und so den Kabelabschnitt auch mechanisch fixieren. Zulaufende bzw. spitze Konturen ermöglichen das Perforieren der Kabelisolierung und somit auch die Kontaktierung von nicht abisolierten Kabelabschnitten. Hier kann auch von einer Zwei-Nadel-Kontaktierung gesprochen werden. Die aus leitendem Material, insbesondere Metall (Kupfer, Gold, Legierung, etc.), gebildeten Kontaktstifte sind nahezu verschleissfrei. Die Kontaktstifte können zusätzlich gefedert sein.

Eine bevorzugte Ausführungsform zeichnet sich dadurch aus, dass das erste Kontaktelement und das zweite Kontaktelement in Richtung der Längsachse der Aufnahme voneinander beabstandet sind, vorzugsweise höchstens 20 mm, bevorzugt höchstens 15 mm. Die dadurch bedingte Beabstandung der ersten und zweiten Kontaktstelle ist besonders vorteilhaft für die bereits erwähnte Vierleitermessung.

Eine bevorzugte Ausführungsform zeichnet sich dadurch aus, dass das erste Kontaktelement und das zweite Kontaktelement von derselben Seite in die Aufnahme ragen oder von derselben Seite in die Aufnahme bewegbar sind. Letzteres kann in diesem Fall durch ein gemeinsames Betätigungselement erfolgen.

Eine bevorzugte Ausführungsform zeichnet sich dadurch aus, dass das erste Kontaktelement an einer Seite der Aufnahme und das zweite Kontaktelement an der dem ersten Kontaktelement gegenüberliegenden Seite der Aufnahme angeordnet ist.

Eine bevorzugte Ausführungsform zeichnet sich dadurch aus, dass das erste Kontaktelement von einer Seite in die Aufnahme bewegbar ist und das zweite Kontaktelement an der dem ersten Kontaktelement gegenüberliegenden Seite der Aufnahme angeordnet oder in die Aufnahme bewegbar ist. Wenn eines oder beide Kontaktelemente beweglich sind kann durch Druckausübung (z.B. durch eine Feder) ein besonders guter Kontakt an beiden Kontaktstellen hergestellt werden.

Eine bevorzugte Ausführungsform zeichnet sich dadurch aus, dass die Aufnahme einen Anschlag zur Beschränkung der Einführbewegung des Kabelabschnittes, insbesondere Kabelendes, aufweist. Hier kann die Kontaktierung des Kabels immer an derselben Stelle erfolgen, wodurch die Reproduzierbarkeit noch weiter verbessert wird

Eine bevorzugte Ausführungsform zeichnet sich dadurch aus, dass der Innendurchmesser der Aufnahme höchstens 5 mm, bevorzugt höchstens 3 mm, beträgt, und/oder dass die Längserstreckung der Aufnahme höchstens 20 mm, bevorzugt höchstens 15 mm, beträgt.

Eine bevorzugte Ausführungsform zeichnet sich dadurch aus, dass die Kabelprüfvorrichtung zumindest zwei, vorzugsweise zumindest fünf, Kontaktiereinrichtungen, die in einem gemeinsamen Block integriert und/oder auf einer gemeinsamen Plattform befestigt sind, umfasst. Dies erlaubt eine platzsparende und kompakte Bauweise sowie die gleichzeitige Prüfung mehrerer Kabel auf engstem Raum.

Die Erfindung erlaubt auch eine sehr schmale Bauweise, z.B. in Reihen oder einer Kreisanordnung und ist auch für mehrpolige Leitungen bestens geeignet.

Die Erfindung betrifft auch ein Verfahren zur Prüfung eines Kabels mittels einer erfindungsgemässen Kabelprüfvorrichtung, wobei vorzugsweise das Verfahren die Schritte:
(a) Einbringen eines ersten Kabelabschnittes eines Kabels, insbesondere eines ersten - vorzugsweise offenen oder steckerlosen bzw. buchsenlosen - Kabelendes, in die Aufnahme der ersten Kontaktiereinrichtung;
(b) Herstellen eines ersten elektrischen Kontaktes zu dem in der Aufnahme befindlichen ersten Kabelabschnitt mittels des ersten Kontaktelements und Herstellen eines zweiten elektrischen Kontaktes zu dem in der Aufnahme befindlichen ersten Kabelabschnitt mittels des zweiten Kontaktelements;
(c) Herstellen zumindest eines elektrischen Kontaktes zu einem zweiten Kabelabschnitt des Kabels, insbesondere einem zweiten - vorzugsweise mit einem Stecker oder einer Buchse bestückten - Kabelende, mittels einer zweiten Kontaktiereinrichtung;
(d) Beaufschlagen des Kabels mit einem Strom oder einer Spannung und Messung eines durch das Kabel geführten Stromes oder einer am Kabel anliegenden Spannung (jeweils über die erste und zweite Kontakteinrichtung).
umfasst. Vorzugsweise umfasst die Kabelprüfvorrichtung eine Vierleitermessanordnung mit einem Kreis zur Beaufschlagung des Kabels mit Strom oder Spannung und einem Messkreis zur Messung eines durch das Kabel geführten Stromes oder einer am Kabel anliegenden Spannung, wobei das erste Kontaktelement Teil des Beaufschlagungskreises und das zweite Kontaktelement Teil des Messkreises ist.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung beschrieben sind.

Die Bezugszeichenliste ist wie auch der technische Inhalt der Patentansprüche und Figuren Bestandteil der Offenbarung. Die Figuren werden zusammenhängend und übergreifend beschrieben. Gleiche Bezugszeichen bedeuten gleiche Bauteile, Bezugszeichen mit unterschiedlichen Indices geben funktionsgleiche oder ähnliche Bauteile an.

Es zeigen dabei:
- Fig. 1: eine Ausführungsform einer erfindungsgemässen Prüfvorrichtung,
- Fig. 2: eine weitere Ausführungsform einer erfindungsgemässen Prüfvorrichtung,
- Fig. 3: eine Prüfvorrichtung in perspektivischer Ansicht,
- Fig. 4: die Leuchteinrichtungen einer bevorzugten Prüfeinrichtung,
- Fig. 5: Integration mehrerer Kontaktiereinrichtungen in einem gemeinsamen Block und auf einer gemeinsamen Plattform,
- Fig. 6: eine Vierleitermessanordnung mit Beaufschlagungskreis und Messkreis

Fig. 1 zeigt eine Kabelprüfvorrichtung 10 mit einer ersten Kontaktiereinrichtung 3 zur temporären elektrischen Kontaktierung eines ersten Kabelabschnittes 5 eines (strichliert dargestellten) Kabels 20, insbesondere eines ersten Kabelendes. Die erste Kontaktiereinrichtung 3 weist eine längliche - in der dargestellten Ausführungsform zylinderförmige - Aufnahme 4 zum Aufnehmen des Kabelabschnittes 5 auf. Im Bereich der Aufnahme 4 sind ein erstes Kontaktelement 1 zur Herstellung eines ersten elektrischen Kontaktes zu dem in der Aufnahme 4 befindlichen Kabelabschnitt 5 und ein zweites Kontaktelement 2 zur Herstellung eines zweiten elektrischen Kontaktes zu dem in der Aufnahme 4 befindlichen Kabelabschnitt 5.

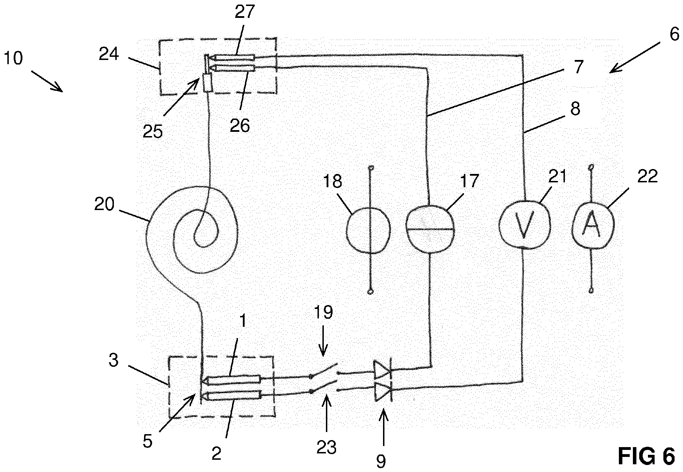

Fig. 6 zeigt, dass die Kabelprüfvorrichtung 10 eine Vierleitermessanordnung 6 mit einem Kreis 7 zur Beaufschlagung des Kabels 20 mit Strom oder Spannung und einem Messkreis 8 (zur Messung einer elektrischen Grösse, wie Spannung, Strom, Widerstand, etc.) umfasst. Das erste Kontaktelement 1 ist dabei Teil des Beaufschlagungskreises 7 und das zweite Kontaktelement 2 Teil des Messkreises 8.

Das erste Kontaktelement 1 kann somit mit einer Stromquelle 17 (oder einer Spannungsquelle 18, welche als Alternative zu Stromquelle bloss angedeutet ist), vorzugsweise über eine Schalteinrichtung 19, verbunden sein. Ebenso kann das zweite Kontaktelement 2 mit einem Voltmeter 21 (oder einem Amperemeter 22, welches als Alternative zum Voltmeter 21 bloss angedeutet ist), vorzugsweise über eine Schalteinrichtung 23, verbunden ist.

Die Kabelprüfvorrichtung 10 kann auch zumindest eine zweite Kontaktiereinrichtung 24 zur temporären elektrischen Kontaktierung eines zweiten Kabelabschnittes 25 des Kabels 20, insbesondere eines zweiten Kabelendes, aufweisen. Alternativ könnte die zweite Kontaktiereinrichtung 24 auch als gesondertes Teil, z.B. in Art eines Adapterteils, vorgesehen sein, welches mit der Prüfvorrichtung elektrisch verbindbar ist.

Auch die zweite Kontaktiereinrichtung 24 kann - ähnlich wie die erste Kontaktiereinrichtung 3 - ein erstes Kontaktelement 26 zur Herstellung eines ersten elektrischen Kontaktes zu dem zweiten Kabelabschnitt 25 und ein zweites Kontaktelement 27 zur Herstellung eines zweiten elektrischen Kontaktes zu dem zweiten Kabelabschnitt 25 umfassen.

Wie in Fig. 6 zu sehen ist das erste Kontaktelement 26 (der zweiten Kontaktiereinrichtung 24) Teil des Beaufschlagungskreises 7 und das zweite Kontaktelement 27 (der zweiten Kontaktiereinrichtung 24) Teil des Messkreises 8.

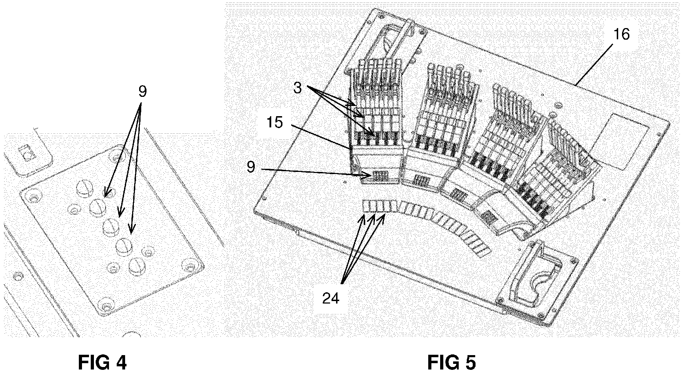

Aus den Fig. 5 und 6 ist zu sehen, dass die Kontaktelemente 1, 2 jeweils mit einer Leuchteinrichtung 9, insbesondere in Form einer Leuchtdiode, zur Anzeige des Kontaktierungszustandes elektrisch verbunden ist/sind.

Wie aus den Fig. 1, 2 und 3 zu sehen kann die Aufnahme 4 eine Führung für den aufzunehmenden Kabelabschnitt 5 ausbilden, wobei die Führung eine Längsachse aufweist.

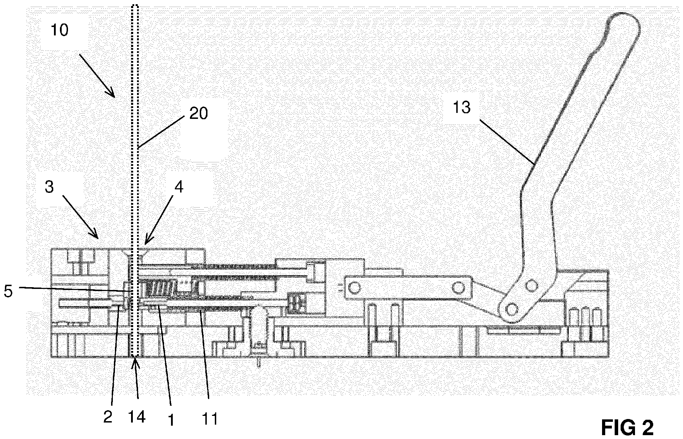

Der in Fig. 1 und 2 gezeigte Mechanismus lässt erkennen, dass zumindest eines der Kontaktelemente 1, 2 (siehe Fig. 2), vorzugsweise beide Kontaktelemente 1, 2 (siehe Fig. 1), relativ zur Aufnahme 4 zwischen einer Trennstellung und einer Kontaktierungsstellung bewegbar ist/sind. Die Bewegungsrichtung der Kontaktelemente 1, 2 steht quer (in der dargestellten Ausführungsform senkrecht) zur Längsachse der Aufnahme 4. Zu sehen ist auch, dass die Kontaktelemente 1, 2 in zumindest einer Stellung, vorzugsweise in der Kontaktierungsstellung, durch eine Feder 11, 12 vorgespannt sein können.

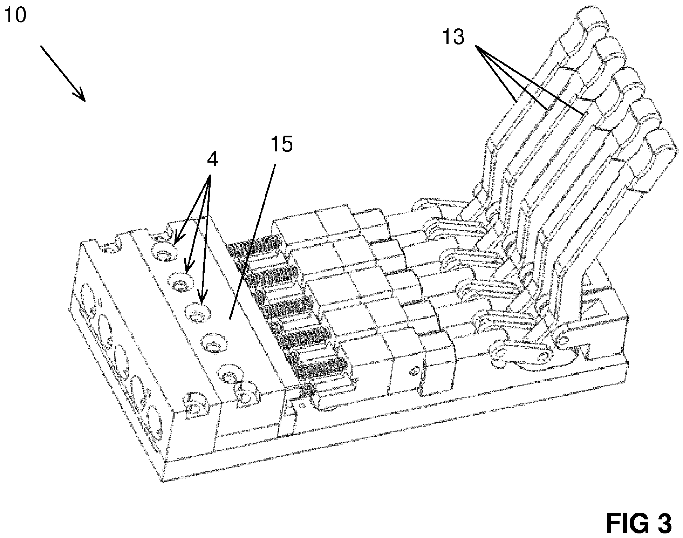

Die Betätigung erfolgt mittels eines Betätigungselementes 13, hier ein schwenkbar gelagerter Hebel. Gemäss der in Fig. 1 - in Verbindung mit Fig. 3 - dargestellten Ausführungsform wirken das erste Kontaktelement 1 und das zweite Kontaktelement 2 mit einem gemeinsamen Betätigungselement 13 zusammen. D.h. sie sind gemeinsam von einer Trennstellung (zurückgezogene, nicht kontaktierende Stellung) in eine Kontaktierungsstellung (in der sie von der Seite in die Aufnahme ragen und gegen den Kabelabschnitt drücken) bewegbar sind.

Es ist bevorzugt, wenn das erste Kontaktelement 1 und das zweite Kontaktelement 2 mit dem Betätigungselement 13 derart verbunden sind, dass beim Betätigen der Betätigungselementes 13 (in die Kontaktierungsstellung) ein Kontaktelement 1 dem anderen Kontaktelement 2 vorauseilt.

Aus Fig. 2 und 3 ist zu erkennen, dass das erste Kontaktelement 1 und/oder das zweite Kontaktelement 2 mit einem Betätigungselement 13 zusammenwirken können, wobei das Betätigungselement 13 Bestandteil einer Kinematik ist, die zwischen der Trennstellung und der Kontaktierungsstellung einen Totpunkt aufweist.

In den dargestellten Ausführungsformen sind die Kontaktelemente 1, 2 jeweils in Form eines Kontaktstiftes, welcher sich quer, vorzugsweise senkrecht, zur Längsachse der Aufnahme 4 erstreckt, ausgebildet. Aus Fig. 1 ist deutlich zu sehen, dass das dem Inneren der Aufnahme 4 zugewandte Ende des Kontaktstiftes vorzugsweise spitz zulaufend (bzw. nadelförmig) ausgebildet ist.

In der Ausführungsform gemäss Fig. 1 sind das erste Kontaktelement 1 und das zweite Kontaktelement 2 in Richtung der Längsachse der Aufnahme 4 voneinander beabstandet - vorzugsweise höchstens 20 mm, bevorzugt höchstens 15 mm. Das erste Kontaktelement 1 und das zweite Kontaktelement 2 ragen von derselben Seite in die Aufnahme 4 ragen bzw. sind von derselben Seite in die Aufnahme 4 bewegbar.

In der alternativen, in Fig. 2 dargestellten Ausführungsform ist das erste Kontaktelement 1 an einer Seite der Aufnahme 4 (hier rechts der Aufnahme 4) und das zweite Kontaktelement 2 an der dem ersten Kontaktelement 1 gegenüberliegenden Seite der Aufnahme 4 (hier links der Aufnahme 4) angeordnet. Das erste Kontaktelement 1 kann z.B. von einer Seite (von links) in die Aufnahme 4 bewegbar sein, während das zweite Kontaktelement 2 an der dem ersten Kontaktelement 1 gegenüberliegenden Seite der Aufnahme 4 stationär angeordnet oder ebenfalls in die Aufnahme 4 bewegbar sein kann.

In Fig. 2 ist zu sehen, dass die Aufnahme 4 einen Anschlag 14 zur Beschränkung der Einführbewegung des Kabelabschnittes 5 bzw. Kabelendes aufweisen kann.

Der Innendurchmesser der Aufnahme 4 beträgt vorzugsweise höchstens5 mm, bevorzugt höchstens 3 mm. Der Innendurchmesser der Aufnahme kann auch an dünnere Kabel abgestimmt sein. Es ist bevorzugt, wenn das Spiel zwischen Kabel und Innenwand der Aufnahme sehr klein ist, sodass dass der zu kontaktierende Kabelabschnitt in definierter Weise positioniert ist. Die Längserstreckung der Aufnahme 4 beträgt vorzugsweise höchstens 20 mm, bevorzugt höchstens 15 mm.

Die Kabelprüfvorrichtung 10 kann zumindest zwei, vorzugsweise zumindest fünf, Kontaktiereinrichtungen 3, die in einem gemeinsamen Block 15 (Fig. 3 und 5) integriert und/oder auf einer gemeinsamen Plattform 16 (Fig. 5) befestigt sind, umfassen.

Die Erfindung betrifft auch ein Verfahren zur Prüfung eines Kabels 20 mittels einer erfindungsgemässen Kabelprüfvorrichtung 10, vorzugsweise mit den Schritten:
(a) Einbringen eines ersten Kabelabschnittes 5 eines Kabels 20, insbesondere eines ersten - vorzugsweise steckerlosen bzw. buchsenlosen - Kabelendes, in die Aufnahme 4 der ersten Kontaktiereinrichtung 3;
(b) Herstellen eines ersten elektrischen Kontaktes zu dem in der Aufnahme 4 befindlichen ersten Kabelabschnitt 5 mittels des ersten Kontaktelements 1 und Herstellen eines zweiten elektrischen Kontaktes zu dem in der Aufnahme 4 befindlichen ersten Kabelabschnitt 5 mittels des zweiten Kontaktelements 2;
(c) Selbstverständlich wird zur Durchführung der Kabelprüfung auch ein zweiter Kabelabschnitt 25, vorzugsweise das zweite (vorzugsweise mit einem Stecker oder einer Buchse bestückte) Kabelende mittels einer zweiten Kontaktiereinrichtung 24 elektrisch kontaktiert (siehe Fig. 6 und Beschreibung weiter oben).
(d) Beaufschlagen des Kabels 20 mit einem Strom oder einer Spannung und Messung eines durch das Kabel 20 geführten Stromes oder einer am Kabel 20 anliegenden Spannung.

Vorzugsweise ist dabei das erste Kontaktelement 1 Teil des Beaufschlagungskreises 7 einer Vierleitermessanordnung 6 und das zweite Kontaktelement 2 Teil des Messkreises 8 der Vierleitermessanordnung 6 ist.

Im Folgenden wird ein - die Erfindung nicht einschränkendes - Beispiel beschrieben: Ein Kabel 20 z.B. mit einer Innenlitze von 0,09 mm² bis 1,5 mm² wird in die erste Kontaktiereinrichtung 3 von oben (bis zum Anschlag) eingeführt. Durch das Betätigen des Hebels der Betätigungseinrichtung 13 werden die zwei Kontaktstifte 1, 2 (in Form von Nadeln (in Fig. 1: nach links) verschoben. Der Kontaktstift 1 ist zum Kontaktstift 2 voreilend, um die Hebelkraft zu minimieren.

Der Kontaktstift 1 sticht die Isolierung des eingeführten Kabels 20 bis zur Innenlitze durch und kontaktiert somit den Kabelabschnitt 5.

Dadurch wird die Leuchteinrichtung 9 (in Form einer LED) auf der LED-Leiste (siehe Fig. 4) mit Strom versorgt über die vertikale Kontaktschraube (ohne BZ) und leuchtet z.B. rot. Beim weiteren Betätigen des Hebels sticht der Kontaktstift 2 durch die Isolierung bis zur (Kupfer)Litze des Kabels 20, dadurch schliesst sich der Stromkreis und die Leuchteinrichtung 9 kann in einer zweiten Farbe, z.B. grün, aufleuchten.

Die Kontaktierung ist damit perfekt und die elektrische Prüfung kann beginnen, d.h. das Kabel kann mit einem Prüfstrom bzw. einer Prüfspannung beaufschlagt werden.

Nach der elektrischen Prüfung wird der Hebel 5 in die andere Richtung betätigt, wodurch die Kontaktstifte 1, 2 zurückfahren und das Kabel 20 wieder aus der Aufnahme 4 entnommen werden kann.

Folgende Unterschiede und Vorteile ergeben sich hier im Vergleich zum Stand der Technik:
- Zwei Nadelkontaktierung;
- Während der Kontaktierung sofortige Anzeige des Kontaktierstatus;
- Echte 4-Leitermessung (Kelvinkontaktierung);
- Manuelle oder automatisierte Bewegung des Hebels;
- Möglichkeit des Einsatzes von gefederten, nahezu verschleissfreie Kontaktstiften
- Hohe Flexibilität, da mit gleicher Kontaktiereinheit verschiedene Kabelquerschnitte (z.B. von 0,09 mm² bis 1,5 mm², aber selbstverständlich auch andere Querschnittsbereiche bei entsprechender Grösse der Aufnahme 4) sicher kontaktiert werden können;
- Sehr schmale Bauweise, Reihen oder Kreisanordnung für mehrpolige Leitungen.

Anstelle der nadelförmigen Kontaktstifte können - gemäss Ausführungsform der Fig. 2 - auch anders geformte Kontaktelemente eingesetzt werden. Ein Einstechen durch nadelförmige Kontaktstifte ist bei abisolierten oder gecrimpten Kabelenden ist nicht erforderlich, da das Kabelende hier direkt kontaktiert werden kann.

Die Erfindung ist nicht auf die beschriebenen Ausführungsformen und die darin hervorgehobenen Aspekte beschränkt. Vielmehr ist innerhalb des Erfindungsgedankens eine Vielzahl von Abwandlungen möglich, die im Rahmen fachmännischen Handelns liegen. Ebenso ist es möglich, durch Kombination der genannten Mittel und Merkmale weitere Ausführungsvarianten zu realisieren, ohne den Rahmen der Erfindung zu verlassen.

### Bezugszeichenliste

- 1: Erstes Kontaktelement
- 2: Zweites Kontaktelement
- 3: Kontakiereinrichtung
- 4: Aufnahme
- 5: Erster Kabelabschnitt
- 6: Vierleitermessanordnung
- 7: Beaufschlagungskreis
- 8: Messkreis
- 9: Leuchteinrichtung
- 10: Kabelprüfvorrichtung
- 11: Feder
- 12: Feder
- 13: Betätigungselement
- 14: Anschlag
- 15: Block
- 16: Plattform
- 17: Stromquelle
- 18: Spannungsquelle
- 19: Schalteinrichtung
- 20: Kabel
- 21: Voltmeter
- 22: Amperemeter
- 23: Schalteinrichtung
- 24: Zweite Kontaktiereinrichtung
- 25: Zweiter Kabelabschnitt
- 26: Erstes Kontaktelement
- 27: Zweites Kontaktelement

## Patentansprüche

1. Kabelprüfvorrichtung (10) mit zumindest einer ersten Kontaktiereinrichtung (3) zur temporären elektrischen Kontaktierung eines ersten Kabelabschnittes (5) eines Kabels (20), insbesondere eines ersten Kabelendes, wobei die zumindest eine erste Kontaktiereinrichtung (3)
- eine, vorzugsweise zylinderförmige, Aufnahme (4) zum Aufnehmen des ersten Kabelabschnittes (5), und
- ein im Bereich der Aufnahme (4) angeordnetes erstes Kontaktelement (1) zur Herstellung eines ersten elektrischen Kontaktes zu einem in der Aufnahme (4) befindlichen ersten Kabelabschnitt (5)
aufweist, **dadurch gekennzeichnet, dass** die zumindest eine erste Kontaktiereinrichtung (3) ein im Bereich der Aufnahme (4) angeordnetes zweites Kontaktelement (2) zur Herstellung eines zweiten elektrischen Kontaktes zu einem in der Aufnahme (4) befindlichen ersten Kabelabschnitt (5) aufweist.

2. Kabelprüfvorrichtung nach Anspruch 1, **dadurch gekennzeichnet, dass** die Kabelprüfvorrichtung (10) eine Vierleitermessanordnung (6) mit einem Kreis (7) zur Beaufschlagung eines Kabels (20) mit Strom oder Spannung und einem Messkreis (8) umfasst, wobei das erste Kontaktelement (1) Teil des Beaufschlagungskreises (7) und das zweite Kontaktelement (2) Teil des Messkreises (8) ist.

3. Kabelprüfvorrichtung nach Anspruch 1 oder 2, **dadurch gekennzeichnet, dass** das erste Kontaktelement (1) mit einer Stromquelle (17) oder einer Spannungsquelle (18), vorzugsweise über eine Schalteinrichtung (19), verbunden ist **und/oder dass** das zweite Kontaktelement (2) mit einem Voltmeter (21) oder einem Amperemeter (22), vorzugsweise über eine Schalteinrichtung (23), verbunden ist.

4. Kabelprüfvorrichtung nach einem der vorhergehenden Ansprüche, **dadurch gekennzeichnet, dass** die Kabelprüfvorrichtung (10) zumindest eine zweite Kontaktiereinrichtung (24) zur temporären elektrischen Kontaktierung eines zweiten Kabelabschnittes (25) eines Kabels (20), insbesondere eines zweiten Kabelendes, aufweist,
wobei vorzugsweise die zumindest eine zweite Kontaktiereinrichtung (24) ein erstes Kontaktelement (26) zur Herstellung eines ersten elektrischen Kontaktes zu dem zweiten Kabelabschnitt (25) und ein zweites Kontaktelement (27) zur Herstellung eines zweiten elektrischen Kontaktes zu dem zweiten Kabelabschnitt (25) umfasst,
wobei vorzugsweise die Kabelprüfvorrichtung (10) eine Vierleitermessanordnung (6) mit einem Kreis (7) zur Beaufschlagung eines Kabels (20) mit Strom oder Spannung und einem Messkreis (8) umfasst, wobei das erste Kontaktelement (26) Teil des Beaufschlagungskreises (7) und das zweite Kontaktelement (27) Teil des Messkreises (8) ist.

5. Kabelprüfvorrichtung nach einem der vorhergehenden Ansprüche, **dadurch gekennzeichnet, dass** das erste Kontaktelement (1) und/oder das zweite Kontaktelement (2) mit einer Leuchteinrichtung (9), insbesondere in Form einer Leuchtdiode, zur Anzeige des Kontaktierungszustandes elektrisch verbunden ist/sind.

6. Kabelprüfvorrichtung nach einem der vorhergehenden Ansprüche, **dadurch gekennzeichnet, dass** die Aufnahme (4) eine Führung für den aufzunehmenden ersten Kabelabschnitt (5) ausbildet, wobei die Führung eine Längsachse aufweist,
**und/oder dass** die Aufnahme (4), zumindest ein Abschnitt des ersten Kontaktelementes (1) und zumindest ein Abschnitt des zweiten Kontaktelementes (2) in einem gemeinsamen Block (15) untergebracht sind.

7. Kabelprüfvorrichtung nach einem der vorhergehenden Ansprüche, **dadurch gekennzeichnet, dass** zumindest eines der Kontaktelemente (1, 2), vorzugsweise beide Kontaktelemente (1, 2), relativ zur Aufnahme (4) zwischen einer Trennstellung und einer Kontaktierungsstellung bewegbar ist/sind, vorzugsweise in einer Richtung quer, bevorzugt senkrecht, zur Längsachse der Aufnahme (4), wobei vorzugsweise zumindest eines der Kontaktelemente (1, 2), vorzugsweise beide Kontaktelemente (1, 2), in zumindest einer Stellung, vorzugsweise in der Kontaktierungsstellung, durch eine Feder (11, 12) vorgespannt ist/sind.

8. Kabelprüfvorrichtung nach einem der vorhergehenden Ansprüche, **dadurch gekennzeichnet, dass** das erste Kontaktelement (1) und das zweite Kontaktelement (2) mit einem gemeinsamen Betätigungselement (13) zusammenwirken und gemeinsam von einer Trennstellung in eine Kontaktierungsstellung bewegbar sind, wobei vorzugsweise das Betätigungselement (13) einen schwenkbar gelagerten Hebel umfasst.

9. Kabelprüfvorrichtung nach Anspruch 8, **dadurch gekennzeichnet, dass** das erste Kontaktelement (1) und das zweite Kontaktelement (2) mit dem Betätigungselement (13) derart verbunden sind, dass beim Betätigen der Betätigungselementes (13) ein Kontaktelement (1) dem anderen Kontaktelement (2) vorauseilt.

10. Kabelprüfvorrichtung nach einem der vorhergehenden Ansprüche, **dadurch gekennzeichnet, dass** das erste Kontaktelement (1) und/oder das zweite Kontaktelement (2) mit einem Betätigungselement (13) zusammenwirken, wobei das Betätigungselement (13) Bestandteil einer Kinematik ist, die zwischen der Trennstellung und der Kontaktierungsstellung einen Totpunkt aufweist.

11. Kabelprüfvorrichtung nach einem der vorhergehenden Ansprüche, **dadurch gekennzeichnet, dass** die Aufnahme (4) eine Längsachse aufweist und dass zumindest eines der Kontaktelemente (1, 2), vorzugsweise beide Kontaktelemente (1, 2), in Form eines Kontaktstiftes, welcher sich quer, vorzugsweise senkrecht, zur Längsachse der Aufnahme (4) erstreckt, ausgebildet ist/sind,
wobei vorzugsweise das dem Inneren der Aufnahme (4) zugewandte Ende des Kontaktstiftes zulaufend, vorzugsweise spitz zulaufend, ausgebildet ist.

12. Kabelprüfvorrichtung nach einem der vorhergehenden Ansprüche, **dadurch gekennzeichnet, dass** das erste Kontaktelement (1) und das zweite Kontaktelement (2) in Richtung der Längsachse der Aufnahme (4) voneinander beabstandet sind, vorzugsweise höchstens 20 mm, bevorzugt höchstens 15 mm,
**und/oder dass** das erste Kontaktelement (1) und das zweite Kontaktelement (2) von derselben Seite in die Aufnahme (4) ragen oder von derselben Seite in die Aufnahme (4) bewegbar sind.

13. Kabelprüfvorrichtung nach einem der vorhergehenden Ansprüche, **dadurch gekennzeichnet, dass** das erste Kontaktelement (1) an einer Seite der Aufnahme (4) und das zweite Kontaktelement (2) an der dem ersten Kontaktelement (1) gegenüberliegenden Seite der Aufnahme (4) angeordnet ist **und/oder dass** das erste Kontaktelement (1) von einer Seite in die Aufnahme (4) bewegbar ist und das zweite Kontaktelement (2) an der dem ersten Kontaktelement (1) gegenüberliegenden Seite der Aufnahme (4) angeordnet oder in die Aufnahme (4) bewegbar ist.

14. Kabelprüfvorrichtung nach einem der vorhergehenden Ansprüche, **dadurch gekennzeichnet, dass** die Aufnahme (4) einen Anschlag (14) zur Beschränkung der Einführbewegung des Kabelabschnittes (5), insbesondere Kabelendes, aufweist
**und/oder dass** der Innendurchmesser der Aufnahme (4) höchstens 5 mm, bevorzugt höchstens 3 mm, beträgt, und/oder dass die Längserstreckung der Aufnahme (4) höchstens 20 mm, bevorzugt höchstens 15 mm, beträgt.

15. Kabelprüfvorrichtung nach einem der vorhergehenden Ansprüche, **dadurch gekennzeichnet, dass** die Kabelprüfvorrichtung (10) zumindest zwei, vorzugsweise zumindest fünf, erste Kontaktiereinrichtungen (3), die in einem gemeinsamen Block (15) integriert und/oder auf einer gemeinsamen Plattform (16) befestigt sind, umfasst.

16. Verfahren zur Prüfung eines Kabels (20) mittels einer Kabelprüfvorrichtung (10), **dadurch gekennzeichnet, dass** die Kabelprüfvorrichtung (10) gemäss einem der vorhergehenden Ansprüche ausgebildet ist, wobei vorzugsweise das Verfahren die Schritte:
(a) Einbringen eines ersten Kabelabschnittes (5) eines Kabels (20), insbesondere eines ersten - vorzugsweise offenen oder steckerlosen bzw. buchsenlosen - Kabelendes, in die Aufnahme (4) der ersten Kontaktiereinrichtung (3);
(b) Herstellen eines ersten elektrischen Kontaktes zu dem in der Aufnahme (4) befindlichen Kabelabschnitt (5) mittels des ersten Kontaktelements (1) und Herstellen eines zweiten elektrischen Kontaktes zu dem in der Aufnahme (4) befindlichen ersten Kabelabschnitt (5) mittels des zweiten Kontaktelements (2);
(c) Herstellen zumindest eines elektrischen Kontaktes zu einem zweiten Kabelabschnitt (25) des Kabels (20), insbesondere einem zweiten - vorzugsweise mit einem Stecker oder einer Buchse bestückten - Kabelende, mittels einer zweiten Kontaktiereinrichtung (24);
(d) Beaufschlagen des Kabels (20) mit einem Strom oder einer Spannung und Messung eines durch das Kabel (20) geführten Stromes oder einer am Kabel (20) anliegenden Spannung
umfasst,
wobei vorzugsweise die Kabelprüfvorrichtung (10) eine Vierleitermessanordnung (6) mit einem Kreis (7) zur Beaufschlagung des Kabels (20) mit Strom oder Spannung und einem Messkreis (8) zur Messung eines durch das Kabel (20) geführten Stromes oder einer am Kabel (20) anliegenden Spannung umfasst, wobei das erste Kontaktelement (1) Teil des Beaufschlagungskreises (7) und das zweite Kontaktelement (2) Teil des Messkreises (8) ist.
